**Europäisches Patentamt**

**European Patent Office**

**Office européen des brevets**

(19)

(11) Numéro de publication: **0 035 432**
**B1**

(12) **FASCICULE DE BREVET EUROPEEN**

(45) Date de publication du fascicule du brevet: **21.12.83**

(51) Int. Cl.³: **H 03 H 15/00**

(21) Numéro de dépôt: **81400267.1**

(22) Date de dépôt: **20.02.81**

(54) Filtre transversal pour modulateur-démodulateur, et modulateur-démodulateur comportant un tel filtre.

(30) Priorité: **26.02.80 FR 8004211**

(43) Date de publication de la demande:
**09.09.81 Bulletin 81/36**

(45) Mention de la délivrance du brevet:
**21.12.83 Bulletin 83/51**

(84) Etats contractants désignés:
**DE GB NL**

(56) Documents cités:
**FR - A - 2 414 835**
**GB - A - 1 210 742**

**RADIO AND ELECTRONIC ENGINEER, vol. 47, no. 6, juin 1977 Londres, GB K. FEHER et al.: "Optimum pulse shaping application of binary transversal filters used in satellite communications", pages 249-256**

(73) Titulaire: **THOMSON-CSF**
**173, Boulevard Haussmann**
**F-75379 Paris Cedex 08 (FR)**

(72) Inventeur: **Picquendar, Jean-Edgar**
**THOMSON-CSF SCPI 173, bld Haussmann**
**F-75360 Paris Cedex 08 (FR)**

(74) Mandataire: **Mayeux, Michèle et al,**
**THOMSON-CSF SCPI 173, Bld Haussmann**
**F-75379 Paris Cedex 08 (FR)**

Courier Press, Leamington Spa, England.

**0 035 432**

Filtre transversal pour modulateur-démodulateur et modulateur-démodulateur comportant un tel filtre

La présente invention concerne un filtre transversal pour modulateur-démodulateur. Elle concerne également les modulateurs-démodulateurs comportant de tels filtres.

On rappelle qu'un modulateur-démodulateur, couramment appelé modem, comporte:

— un modulateur, qui convertit une suite aléatoire de signaux binaires égaux à 0 ou à 1 en un signal analogique périodique, modulé en fréquence, en amplitude ou en phase, et transmissible par le réseau téléphonique;

— un démodulateur, qui convertit le signal analogique modulé fourni par le réseau en une suite de 0 ou de 1.

La présente invention concerne les modems à modulation de fréquence qui sont connus sous le vocable anglo-saxon de Frequency Shift Keying ou F.S.K.

Dans les modems F.S.K., à un zéro, le modulateur fait correspondre une sinusoïde à la fréquence $F_A$ et à un un, le modulateur fait correspondre une sinusoïde à la fréquence $F_Z$.

Les spécifications du C.C.I.T.T. prévoient toutes les caractéristiques des modems, c'est ainsi qu'un modem à 1200 bauds a été étudié pour lequel $F_A=2100$ Hz et $F_Z=1300$ Hz. Ce modem fonctionne en duplex (c'est-à-dire en utilisant simultanément la même ligne) avec un autre modem à 75 bauds pour lequel $F_A=450$ Hz et $F_Z=390$ Hz.

Le modem à 1200 bauds sera cité à titre d'exemple dans ce qui suit.

Les modems comportent de nombreux filtres et notamment un filtre de sortie du modulateur et d'entrée du démodulateur qui ont généralement la même caractéristique.

Dans l'exemple du modem à 1200 bauds, les filtres de sortie du modulateur et d'entrée du démodulateur sont des filtres passebandes qui sont passants à partir de 500 Hz environ et jusqu'à environ 4000 Hz.

Le modem à 1200 bauds ne doit pas transmettre sur la ligne des informations en dessous de 500 Hz car ces informations perturberaient celles transmises sur la même ligne par le modem à 75 bauds.

Dans l'art antérieur, les filtres de sortie du modulateur et d'entrée du démodulateur étaient constitués de deux filtres actifs en série: l'un, passe-haut, passant au-dessus de 500 Hz et l'autre, passe-bas, passant jusqu'à 4000 Hz.

La transformée en z de la fonction de transfert des filtres actifs s'écrit: $P(z)/Q(z)$, avec le degré du polynôme $Q(z)$ égal à celui de $P(z)$. Les filtres actifs présentent donc autant de pôles que de zéro et leur réponse impulsionnelle est infinie.

De plus, les filtres actifs présentent de la distorsion de temps de groupe.

L'inconvénient des filtres actifs selon l'art antérieur est que, du fait de leur réponse impulsionnelle infinie et de leur distorsion de temps de groupe, ils peuvent provoquer une superposition sur la ligne des signaux à 1300 et 2100 Hz ce que provoque des erreurs à la démodulation.

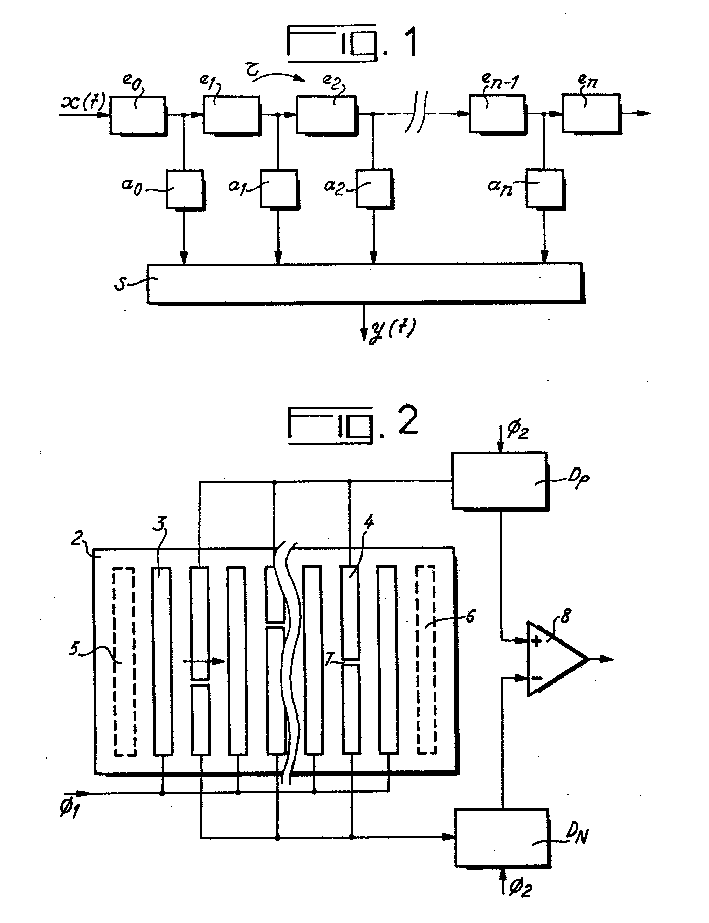

De même, on connaît dans l'art antérieur par la demande de brevet français N° 78.19141 publiée sous le N° 2.414.835 au nom de Texas Instruments, et notamment par la figure 1 de cette demande, un démodulateur qui comporte trois filtres BPF 1, BPF 2 et BPF 3 qui sont montés en parallèle à l'entrée du démodulateur. Chacun de ces filtres se trouve en série avec un interrupteur SW 1, SW 2 et SW 3 qui permet de sélectionner l'un des trois filtres en fonction de la bande de fréquence couverte par le signal à demoduler. Ces trois filtres sont des filtres transversaux, de caractéristique passe-bande, qui peuvent être réalisés de façon bien connue en technologie C.C.D. (Charge Coupled Devices).

Comme les filtres actifs, ces filtres présentent l'inconvénient d'avoir une réponse inpulsionnelle dont la durée n'est pas suffisamment limitée.

La présente invention concerne un filtre transversal pour modulateur-démodulateur qui comporte un registre à décalages de $n+1$ étages qui reçoit un signal d'entrée échantillonné $x(t)$. Le décalage d'un échantillon d'un étage au suivant se fait avec un retard $\tau$ et le signal de sortie $y(t)$ est constitué par la somme, à un même instant t, des signaux pris sur chaque étage et affectués d'un coefficient du pondération $a_o \ldots a_n$. Le signal $y(t)$ égale donc:

$$y(t)=a_o \cdot x(t)+a_1 \cdot x(t-\tau)+a_2 \cdot x(t-2\tau) \ldots +a_n \cdot x(t-n\tau)$$

Selon l'invention, le nombre n est limité de façon que la relation suivante soit vérifiée:

$$n<\frac{1}{\tau} \cdot \frac{1}{k},$$

où k représente le nombre de bauds du modem qui comporte le filtre selon l'invention.

Le filtre selon l'invention peut être un filtre numérique ou à transfert de charges.

2

**0 035 432**

Le filtre selon l'invention peut être utilisé comme filtre de sortie du modulateur, comme filtre d'entrée du démodulateur ou comme filtre de sortie du démodulateur.

Enfin, on peut utiliser deux filtres analogues à celui de l'invention pour réaliser la démodulation des signaux analogiques issus de la ligne.

Le filtre selon l'invention présente de nombreux avantages parmi lesquels on peut citer:

— sa réponse impulsionnelle limitée à la durée du baud du modem dont il fait partie et son temps de groupe constant en fonction de la fréquence. Ces deux caractéristiques permettent d'éviter la superposition sur la ligne des signaux aux fréquences $F_A$ et $F_Z$;
— sa grande facilité d'intégration dans le cas où il s'agit d'un filtre à transfert de charges;
— enfin, le fait qu'il soit programmable en fréquence, simplement en modifiant la fréquence du signal qui assure le décalage d'un échantillon d'un étage du registre au suivant.

D'autres objets, caractéristiques et résultats de l'invention ressortiront de la description suivante, donnée à titre d'exemple non limitatif et illustrée par les figures annexées qui représentent:

— les figures 1 et 2, les schémas d'un filtre transversal selon l'invention et d'un filtre transversal à transfert de charges selon l'invention;
— la figure 3, la représentation dans le plan complexe des zéros du filtre selon l'invention;
— les figures 4 et 5, l'allure des fonctions de transfert obtenues avec le filtre selon l'invention;
— les figures 6, 7 et 8, les schémas de démodulateurs selon l'invention;
— les figures 9a à 9e, les signaux obtenus en divers points du démodulateur selon la figure 6.

Sur les différentes figures, les mêmes repères désignent les mêmes éléments, mais, pour des raisons de clarté, les cotes et proportions des divers éléments ne sont pas respectées.

Le filtre représenté sur la figure 1 est un filtre transversal qui comporte un registre à décalages constitué de n+1 étages $e_o$ à $e_n$. Ce filtre reçoit un signal d'entrée échantillonné x(t). Le décalage d'un échantillon du signal d'entrée d'un étage au suivant se fait avec un retand $\tau$.

Le signal de sortie du filtre y(t) est constitué par la somme réalisée par un dispositif de sommation S, à un même instant t, des signaux pris sur chaque étage et affectés d'un coefficient de pondération $a_o$, $a_1, a_2 \ldots a_n$. Le signal de sorite y(t) égale donc

$$y(t)=a_o \cdot x(t)+a_1 \cdot x(t-\tau)+a_2 \cdot x(t-2\tau)+\ldots+a_n \cdot x(t-n\tau).$$

La durée de la réponse impulsionnelle d'un tel filtre transversal égale: $n\tau$.

On rappelle que la réponse impulsionnelle h(t) est égale à la transformée inverse de Fourrier et s'écrit:

$$h(t)=\int_{-\infty}^{+\infty} A(\omega) \cdot e^{j\omega 5} d\omega,$$

où $A(\omega)$ est le transformée de Fourrier qui égale:

$$A(\omega)=\int_{-\infty}^{+\infty} h(t) \cdot e^{j\omega t} dt.$$

Selon l'invention, on limite le nombre n, et donc le nombre n+1 d'etages du registre à décalage, de façon que la relation suivante soit vérifiée:

(1)
$$n < \frac{1}{\tau} \cdot \frac{1}{k},$$

où k représente le nombre de bauds du modulateur-démodulateur qui comporte ce filtre transversal.

On rappelle qu'on n'a pas le droit de transmettre sur la ligne deux transitions successives séparées par une durée intérieure à celie du baud.

Si on dispose d'un modem à k bauds, la valeur du baud égale 1/k. Ainsi dans le cas d'un modem à 1200 bauds, on n'a pas le droit de transmettre sur la ligne deux transitions successives séparées par moins de 1 baud=1/1200=833 $\mu$s.

Pour éviter la superposition sur la ligne des signaux à 1300 et 2100 Hz, il faut limiter la durée de la réponse impulsionnelle, $n\tau$, à la valeur du baud, ce qui donne:

$$n\tau < \frac{1}{k} \text{ et } n < \frac{1}{\tau} \cdot \frac{1}{k}$$

qui est la relation (1) précédemment citée.

3

De plus, pour que le filtre selon l'invention n'introduise pas de distorsion de temps de groupe, il faut que les coefficients de pondération $a_o$...$a_n$ soient symétriques deux à deux, mis à part le coefficient central lorsque le nombre de coefficients est impair.

On rappelle qu'il y a distorsion de temps de groupe lorsque le déphasage introduit par le filtre ne varie pas linéairement en fonction de la fréquence.

Avec sa réponse impulsionnelle limitée à la durée du band du modem dont il fait partie et son temps de groupe constant en fonction de la fréquence, le filtre selon l'invention permet d'éviter la superposition sur la ligne des signaux aux fréquences $F_A$ et $F_Z$.

Le filtre selon l'invention peut être un filtre numérique ou un filtre à transfert de charges.

Dans le cas du filtre numérique, ou entre dans un registre à décalages à une fréquence $1/\tau$, la valeur codée en numérique d'échantillons du signal d'entrée. Chaque échantillon passe d'un étage du registre au suivant à une fréquence $1/\tau$. On effectue $n+1$ multiplications entre le contenu de chaque étage et un coefficient de pondération $a_o$...$a_n$ contenu dans une mémoire. La somme du résultat de ces $n+1$ multiplications donne en numérique le signal filtré.

La figure 2 donne le schéma d'un filtre transversal à transfert de charges du type C.C.D. (Charge Coupled Device).

Les filtres à transfert de charges, qui sont bien connus de l'art antérieur, sont constitués par un substrat semi-conducteur recouvert d'une couche isolante 2 sur laquelle alternent des électrodes de transfert 3 et des électrodes de stockage des charges 4, disposées perpendiculairement au sens de transfert des charges indiqué par une flèche.

Aux deux extrêmités du dispositif, deux diodes 5 et 6 assurent respectivement l'injection dans le substrat de charges électriques, qui sont les porteurs minoritaires du substrat, et l'evacuation de ces charges.

Sur application aux électrodes de transfert et de stockage de signaux d'horloge $\phi_1$ et $\phi_2$, de même période mais en opposition de phase, il y a transfert de charges d'une électrode de stockage à la suivante.

Pour qu'il y ait continuité des potentiels crées dans le substrat semi-conducteur sous les électrodes et pour qu'il y ait un sens de transfert des charges unique, on dispose les électrodes de stockage sur une surépaisseur d'isolant.

Cette surépaisseur d'isolant peut être remplacée par un surdosage du substrat par implantation d'ions qui assure les mêmes fonctions.

De même la description est faite dans le cas de dispositifs à transfert de charges à deux phases $\phi_1$ et $\phi_2$ mais l'invention s'applique aussi bien aux dispositifs à transfert de charges à trois phases par exemple qui comportent deux électrodes de transfert entre chaque électrode de stockage.

Les électrodes de stockage 4 sont séparées en au moins deux parties par une coupure 7 disposée selon la direction de transfert des charges.

Lors de l'arrivée des charges sous une électrode de stockage, les charges stockées sous chaque partie de cette électrode sont lues par un dispositif de lecture des charges $D_p$ et $D_N$, comme cela est représenté sur la figure 2.

Les dispositifs de lecture des charges $D_p$ et $D_N$ sont reliés à un amplificateur différentiel 8 qui permet d'obtenir un signal pondéré positivement ou négativement selon la position de la coupure 7.

Les dispositifs de lecture des charges en courant ou en tension sont bien connus de l'art antérieur, notamment par la demande de brevet français N° 77.13857 publiée sous le N° 2.389.899 au nom de Thomson-CSF.

Les filtres transversaux à transfert de charges comportent donc un registre à décalages constitué d'électrodes de transfert 3 et d'électrodes de stockage 4.

Chaque étage de ce registre comporte une électrode de stockage 4 séparée en deux parties par une coupure 7 et une ou plusieurs électrodes de transfert 3.

Si on prend l'exemple du modem à 1200 bauds pour lequel

$$\frac{1}{\tau}=32000 \text{ Hz},$$

on obtient en appliquant la relation (1):

$$n<\frac{1}{1200} . 32\,000,$$

c'est-à-dire $n<26,6$.

Par conséquent, les filtres transversaux à transfert de charges utilisés dans ce modem ne devront pas comporter plus de $n+1=27$ étages, si on choisit $n$ égal à 26.

Nous allons prendre l'exemple du filtre de sortie du modulateur et du filtre d'entrée du démodulateur du modem à 1200 bauds qui comme nous l'avons vu précédemment doivent être passants de 500 Hz à 4000 Hz environ.

4

**0 035 432**

Ces filtres peuvent donc être réalisés par des filtres transversaux à transfert de charges comportant 27 étages donc 27 électrodes des stockage et 27 coefficients de pondération.

La transformé en z du signal de sortie de ces filtres s'écrit:

$$y(z)=(a_o+a_1z+a_2z^2+\ldots+a_nz^n) \cdot e^{j\omega t}=(z-b_1) \cdot (z-b_2)\ldots(z-b_n) \cdot e^{j\omega k}.$$

Nous allons réaliser la synthèse de ces filtres en déterminant leurs n zéros $b_1$ à $b_n$, c'est-à-dire les valeurs de z qui annulent y(z).

Nous savons déjà que les zéros de y(z) sont deux à deux conjugués, par conséquent, il suffit de fixer les valeurs de n/2 zéros, c'est-à-dire de 13 zéros dans l'exemple considéré.

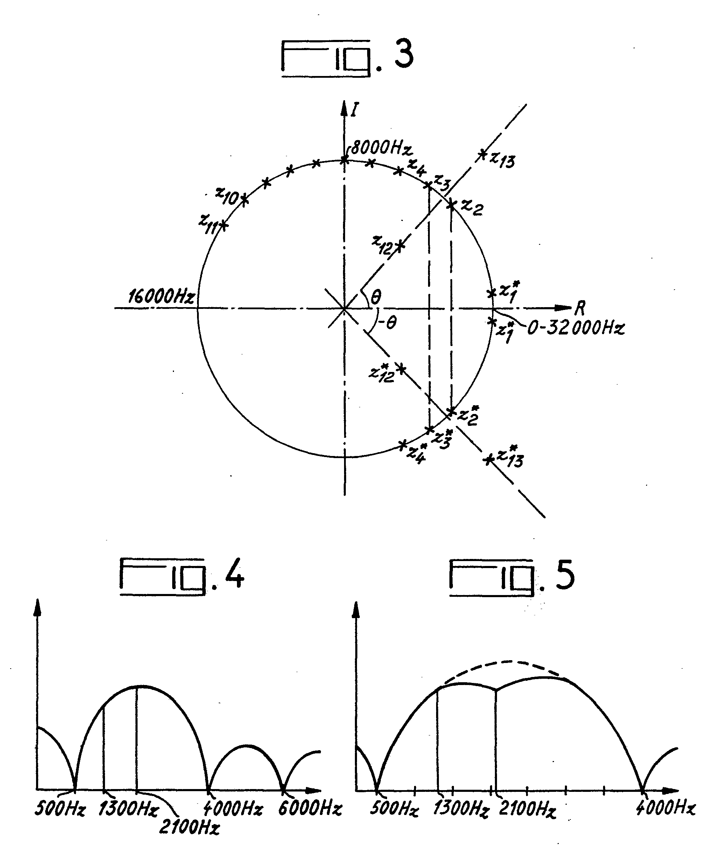

Sur la figure 3, on a représenté dans le plan complexe les zéros de ces filtres et sur la figure 4, on a représenté la fonction de transfert obtenue. Les zéros sont positionnés sur le cercle de rayon unité dont on effectue un tour complet en un temps $\tau$ égal à 1/32000 Hz.

Il y a deux zéros obligatoires, l'un à 500 Hz, $z_1$ et l'autre à 4000 Hz, $z_2$.

On utilise ensuite neuf zéros, $z_3$ à $z_{11}$ pour éliminer les fréquences élevées.

Ces neuf zéros peuvent être placés par exemple à 6000 Hz, 7000 Hz, 8000 Hz...

Sur la figure 4, on peut constater que le 1300 Hz passe moins bien que le 2100 Hz, les deux zéros disponibles $z_{12}$ et $z_{13}$ vont être utilisés pour corriger cela.

On dispose un zéro $z_{12}$ à 2100 Hz mais à l'intérieur du cercle. Ce zéro s'écrit $\rho e^{j\phi}$ avec $\rho<1$. La valeur de $\rho$ est choisie pour que le 1300 et le 2100 Hz passent de la même façon, comme cela est représente sur la figure 3.

On sait par ailleurs que pour qu'il n'y ait pas de distorsion de temps de groupe, les coefficients de la transformée en z doivent être symétriques deux à deux, mis à part le coefficient central lorsqu'il existe.

On a introduit un couple de zéros:

$$z_{12}=\rho e^{j\phi} \text{ et } z_{12}^*=\rho e^{-j\phi}.$$

Pour que la condition précédemment énoncée soit réalisée, il suffit de choisir un couple de zéros:

$$z_{13}=\frac{1}{\rho} \cdot e^{j\phi} \text{ et } z_{13}^*=\frac{1}{\rho} \cdot e^{-j\phi}.$$

Les n zéros $b_1$ à $b_n$ des filtres considérés ont donc été déterminés. En passant de l'expression de y(z) sous forme de produit à son expression polynôminale, on détermine les n+1 coefficients de pondération $a_o$ à $a_n$. En fonction de la valeur de ces coefficients, la position de la coupure 7 sur les électrodes de pondération est déterminée.

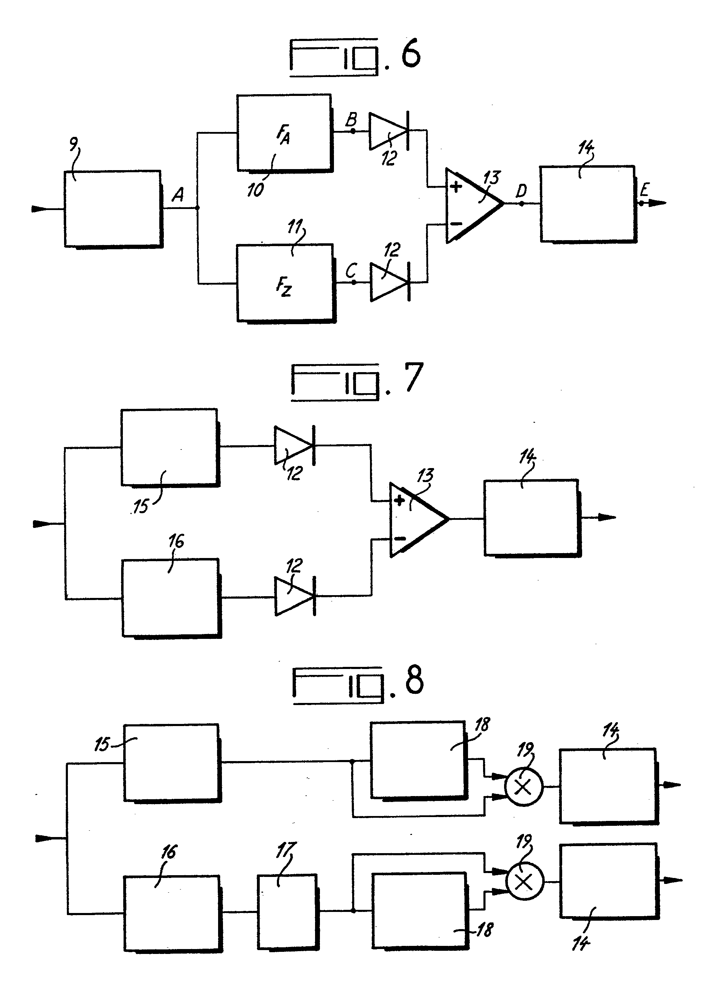

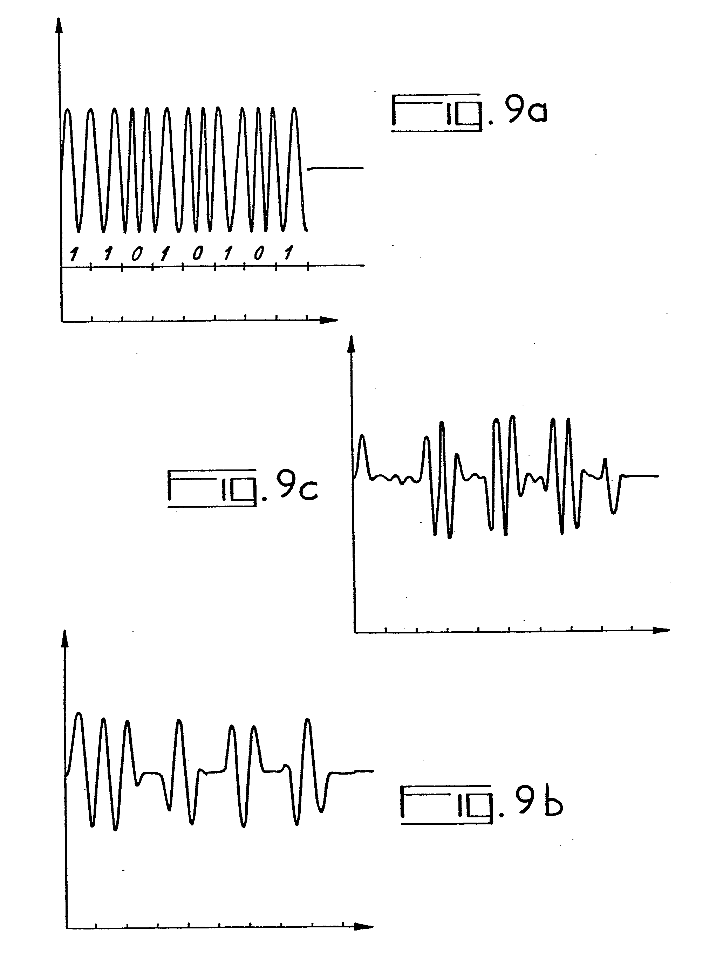

Les figures 6 et 7 représentent deux modes de réalisation d'un démodulateur selon l'invention.

Ce démodulateur comporte un filtre d'entrée 9 transversal à transfert de charges qui est semblable à celui dont il a été question précédemment.

Ce démodulateur comporte ensuite deux voies en parallèle avec sur chaque voie un filtre transversal à transfert de charge 10 et 11 selon l'invention et un dispositif redresseur double alternance constitué de diodes 12.

Les filtres 10 et 11 comportent un nombre d'électrodes de stockage limité en fonction du nombre de bauds du modem dont ces filtres font partie. Les coefficients de pondération de ces filtres sont symétriques deux à deux pour qu'il n'y ait pas de distorsion de temps de groupe.

De plus, on a choisi pour le filtre 10 de placer un zéro à la fréquence $F_A$, et pour le filtre 11 de placer un zéro à la fréquence $F_Z$.

En sortie du filtre 10, on trouve donc un signal qui correspond au signal d'entrée et dans lequel la fréquence $F_A$ a été supprimée et en sortie du filtre 11, on trouve un signal qui correspond au signal d'entrée et dans lequel la fréquence $F_Z$ a été supprimée.

Ce sont ces signaux qui sont soumis à un redressement double alternance en 12 puis qui sont envoyés sur un amplificateur différentiel 13 qui permet de distinguer les signaux à $F_A$, négatifs par exemple, de ceux à $F_Z$ positifs.

Après l'amplificateur differentiel 13, on trouve un filtre 14, tranversal à transfert de charges selon l'invention qui supprime les sortie de l'amplificateur différentiel, c'est-à-dire deux niveaux continus de signe différent pour $F_A$ et $F_Z$.

Sur les figures 9a à 9e, sont représentés les signaux obtenus en divers points du démodulateur de la figure 6.

Sur la figure 9a, on trouve le signal au point A en sortie du filtre 9.

Ce signal est constitué d'une suite de sinusoïdes aux fréquences $F_A$ et $F_Z$, correspondant à une suite de 0 et de 1.

Sur la figure 9b, on trouve le signal à la sortie du filtre 10 au point B. Ce signal ne comporte plus de sinusoïde à la fréquence $F_A$.

5

# O 035 432

De même sur la figure 9c, on trouve le signal à la sortie du filtre 11 au point C qui ne comporte plus de sinusoïde à la fréquence $F_z$.

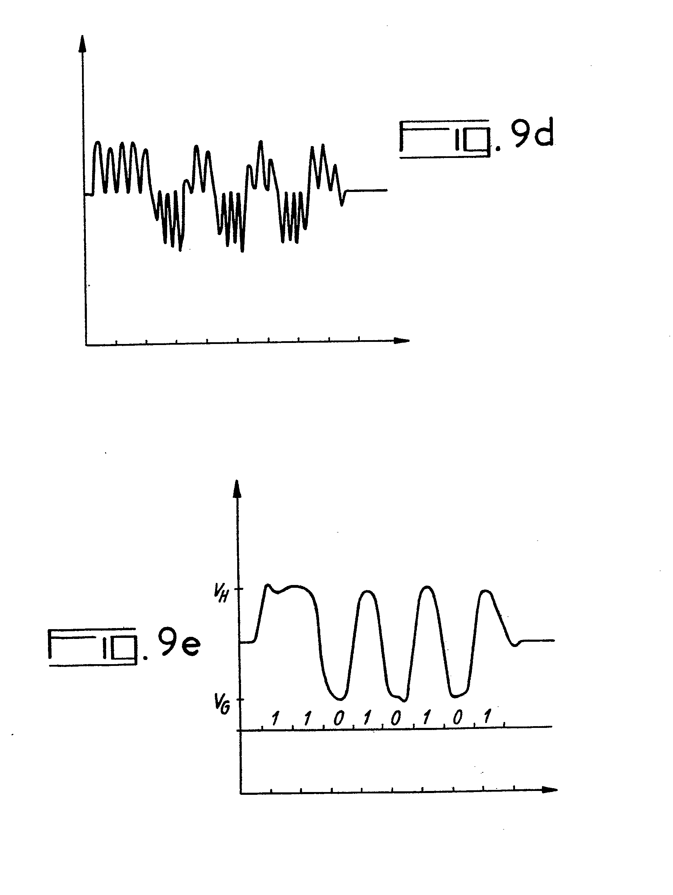

Sur la figure 9d, on trouve le signal après l'amplificateur différentiel 13 au point D.

Le signal à $F_A$ redressé double alternance est négatif alors que le signal à $F_z$ redressé double alternance est positif.

Sur la figure 9e, on trouve le signal au point E en sortie du filtre 14. Ce signal comporte un niveau haut $V_H$ et un niveau bas $V_B$ qui correspondent repectivement à un un et à un zéro.

Sur la figure 8, on a représenté un autre mode de réalisation du démodulateur selon l'invention qui diffère de celui de la figure 6 par le fait que le filtre d'entrée 9 est supprimé et que les deux voies en parallèle comportent des filtres 15 et 16 selon l'invention qui jouent le rôle des filtres 9 et 10, et 9 et 11 de la figure 6. Il suffit pour cela de réaliser un filtre 15 qui comporte les zéros du filtre 9 à l'exception d'un zéro aux fréquences élevées qui est remplacé par un zéro à $F_A$. Il en est de même pour le filtre 16 qui comporte les zéros du filtre 9, à un près, et un zéro supplémentaire à $F_z$.

Sur la figure 8 enfin, est représenté un autre mode de réalisation du démodulateur selon l'invention.

Ce démodulateur diffère de celui de la figure 7 car il comporte un égalisateur de temps de groupe programmable 17.

Cet égalisateur est destiné à compenser la distorsion de temps de groupe due à la ligne qui n'est pas la même pour les lignes d'abonnés et les lignes de longue distance.

Cet égalisateur est constitué par un registre à transfert de charges situé sur l'une des voies qui apporte au signal un retard programmable en agissant sur la fréquence d'horloge du registre à décalages.

Enfin, le mode de réalisation de la figure 8 diffère de celui de la figure 7 car la détection n'est pas réalisée par des diodes 12.

La détection est réalisée de façon connue en effectuant la multiplication par un dispositif 19 entre le signal et ce même signal retardé par une ligne à retard 18.

La ligne à retard 18 est constituée par un registre à décalages à transfert de charges.

## Revendications

1. Filtre transversal pour modulateur-démodulateur, comportant un registre à décalages de $n+1$ étages ($e_o$, $e_1 \ldots e_n$) qui reçoit un signal d'entrée échantillonné x(t), le décalage d'un échantillon d'un étage au suivant se faisant avec un retard $\tau$ et le signal de sortie y(t), constitué par la somme à un même instant t des signaux pris sur chaque étage et affectés d'un coefficient de pondération $a_o \ldots a_n$, étant égal à y(t)=

$$a_o \cdot x(t) + a_1 \cdot x(t-\tau) + a_2 \cdot x(t-2\tau) + \ldots + a_n \cdot x(t-n\tau),$$

caractérisé en ce que le nombre n, et donc le nombre $n+1$ d'étages du registre, est limité de façon que la relation suivante soit vérifiée:

$$n < \frac{1}{\tau} \cdot \frac{1}{k},$$

où k représente le nombre de bauds du modulateur-démodulateur qui comporte ce filtre transversal.

2. Filtre selon la revendication 1, caractérisé en ce que les coefficients de pondération $a_o \ldots a_n$ sont symétriques deux à deux, mis à part le coefficient central lorsque le nombre de coefficients est impair.

3. Filtre transversal à transfert de charges selon l'une des revendications 1 ou 2, caractérisé en ce que chaque étage comporte une électrode de stockage (4) séparée en deux parties par une coupure (7) dont la position détermine la valeur du coefficient de pondération et une ou plusieurs électrodes de transfert (3).

4. Filtre selon l'une des revendications 1 à 3, caractérisé en ce que les zéros du filtre sont fixés en fonction des fréquences à éliminer par le filtre.

5. Modulateur-démodulateur, caractérisé en ce qu'il comporte au moins un filtre transversal à transfert de charges selon l'une des revendications 1 à 4.

6. Modulateur-démodulateur selon la revendication 3, caractérisé en ce que le démodulateur comporte deux voies en parallèle avec sur chaque voie un filtre transversal à transfert de charges, (10, 11) ayant respectivement un zéro à la fréquence $F_A$ et un zéro à la fréquence $F_z$.

7. Modulateur-démodulateur selon la revendication 6, caractérisé en ce que l'une des voies comporte un égalisateur de temps de groupe de la ligne programmable (17) constitué par un registre à décalages à transfert de charges, est égalisateur étant connecté en série avec le filtre transversal à transfert de charges de cette voie.

8. Modulateur-démodulateur selon l'une des revendications 6 ou 7, caractérisé en ce que chaque voie comporte, connectés en série avec le filtre transversal à transfert de charge de cette voie, une ligne

6

à retard (18) constituée par un registre à décalages à transfert de charges suivie par un dispositif de multiplication (19) entre le signal issu de la ligne à retard et le signal avant la ligne à retard.

**Patentansprüche**

1. Transversalfilter für einen Modulator-Demodulator, mit einem Schieberegister, das $n+1$ Stufen $(e_o, e_1 \ldots e_n)$ aufweist und ein getastetes Eingangssignal $x(t)$ empfängt, wobei die Verschiebung einer Abtastprobe von einer Stufe zur nächsten mit einer Verzögerung $\tau$ erfolgt und das Ausgangssignal $y(t)$, welches durch die Summe der zur selben Zeit $t$ an jeder Stufe abgenommenen und mit einem Wichtungskoeffizienten $a_o \ldots a_n$ behafteten Signale gebildet ist, folgende ist: $y(t) =$

$$a_o . x(t) + a_1 . x(t-\tau) + a_2 . x(t-2\tau) + \ldots + a_n . x(t-n\tau),$$

dadurch gekennzeichnet, daß die Anzahl n, und folglich die Anzahl n+1 von Registerstufen derart begrenzt ist, daß die folgende Beziehung gilt:

$$n < \frac{1}{\tau} . \frac{1}{k},$$

worin k die Anzahl von baud des Modulators-Demodulators ist, der dieses Transversalfilter enthält.

2. Filter nach Anspruch 1, dadurch gekennzeichnet, daß die Wichtungskoeffizienten $a_o \ldots a_n$ zwei zu zwei symmetrisch sind, abgesehen von dem zentralen Koeffizienten, wenn die Anzahl von Koeffizienten ungerade ist.

3. Transversalfilter, das mit Ladungsverschiebung arbeitet, nach einem der Ansprüche 1 und 2, dadurch gekennzeichnet, daß jede Stufe eine Speicherelektrode (4), die durch einen Schnitt (7) in zwei Teile geteilt ist, dessen Lage den Wert des Wichtungskoeffizienten bestimmt, und eine oder mehrere Verschiebeelektroden (3) umfaßt.

4. Filter nach einem der Ansprüche 1 bis 3, dadurch gekennzeichnet, daß die Nullen des Filters in Abhängigkeit von den durch das Filter zu eliminierenden Frequenzen festgelegt sind.

5. Modulator-Demodulator, dadurch gekennzeichnet, daß er wenigstens ein mit Ladungsverschiebung arbeitendes Transversalfilter nach einem der Ansprüche 1 bis 4 enthält.

6. Modulator-Demodulator nach Anspruch 5, dadurch gekennzeichnet, daß der Demodulator zwei parallele Zweige umfaßt, wobei in jedem Zweig ein mit ladungsverschiebung arbeitendes Transversalfilter (10, 11) angeordnet ist, von denen das eine eine Null bei der Frequenz $F_A$ und das andere eine Null bei der Frequenz $F_Z$ aufweist.

7. Modulator-Demodulator nach Anspruch 6, dadurch gekennzeichnet, daß einer der Zweige ein programmierbares Ausgleichsglied (17) zum Ausgleichen der Gruppenlaufzeit der Leitung umfaßt, welches durch ein mit Ladungsverschiebung arbeitendes Schieberegister gebildet ist, wobei dieses Ausgleichsglied in Reihe mit dem mit Ladungsverschiebung arbeitenden Transversalfilter dieses Zweiges geschaltet ist.

8. Modulator-Demodulator nach einem der Ansprüche 6 und 7, dadurch gekennzeichnet, daß jeder Zweig, in Reihe mit dem mit Ladungsverschiebung arbeitenden Transversalfilter dieses Zweiges geschaltet, eine Verzögerungsleitung (18) umfaßt, die durch ein mit Ladungsverschiebung arbeitendes Register gebildet ist, auf das eine Multiplikationsvorrichtung (19) folgt, welche das von der Verzögerungsleitung abgegebene Signal mit dem Signal vor der Verzögerungsleitung multipliziert.

**Claims**

1. Transverse filter for a modulator/demodulator, comprising a shaft register having n+1 stages $(e_o, e \ldots e_n)$ receiving a sampled input signal $x(t)$, the shifting of one sample from one stage to the next being performed with a delay of $\tau$ and the output signal $y(t)$ which is the sum of the signals taken from each stage at the same time and subject to a weighting coefficient $a_o \ldots a_n$, being: $y(t) =$

$$a_o . x(t) + a_1 . x(t-\tau) + a_2 . x(t-2\tau) + \ldots + a_n . x(t-n\tau),$$

characterized in that the number n, and thus the number n+1 of stages of the register is limited in a manner to obtain the following relation:

$$n < \frac{1}{\tau} . \frac{1}{k},$$

wherein k represents the number of baud of the modulator/demodulator comprising this transverse filter.

7

2. Filter according to claim 1, characterized in that the weighting coefficients $(a_o...a_n)$ are symmetrical two by two, with the exception of the central coefficient in case of an odd number of coefficients.

3. Transverse charge coupled filter according to any of claims 1 and 2, characterized in that each stage comprises a storage electrode (4) separated into two paths by a cut (7) the position of which determines the value of the weighting coefficient, and one or a plurality of transfer electrodes (3).

4. Filter according to any of claims 1 to 3, characterized in that the zeroes of the filter are determined in dependence on the frequency to be eliminated by the filter.

5. Modulator/demodulator, characterized in that it comprises at least one transverse charge coupled filter according to any of claims 1 to 4.

6. Modulator/demodulator according to claim 5, characterized in that the demodulator comprises two parallel branches, each branch comprising a transverse charge coupled filter (10, 11) having a zero at the frequency $F_A$ and a zero at the frequency $F_Z$, respectively.

7. Modulator-demodulator according to claim 6, characterized in that one of the branches comprises a programmable line group delay equalizer (17) formed of a charge coupled shift register and connected in series with the charge coupled transverse filter of this branch.

8. Modulator/demodulator according to claims 6 or 7, characterized in that each branch comprises, in series with the charge coupled transverse filter of this branch, a delay line (18) formed of a charge coupled shift register followed by a multiplication device (19) multiplying the output signal of the delay line with its input signal.

Fig. 1

Fig. 2

# Fig. 3

# Fig. 4

# Fig. 5

0 035 432

FIG. 6

FIG. 7

FIG. 8

3

Fig. 9a

1 1 0 1 0 1 0 1

Fig. 9c

Fig. 9b

FIG. 9d

FIG. 9e

$V_H$

$V_G$

1  1  0  1  0  1  0  1